# FASCICULE DE BREVET EUROPEEN

(11) **EP 3 078 085 B1**
(45) Date de publication et mention de la délivrance du brevet: **06.11.2019**
(21) Numéro de dépôt: 14805927.2
(22) Date de dépôt: 02.12.2014
(51) Int. Cl.: H01R 13/60, H01R 27/02, G06F 1/26, H05K 7/14

(54) **MODULE ÉLECTRIQUE**
ELEKTRISCHES MODUL
ELECTRICAL MODULE

(30) Priorité: 05.12.2013 FR 1362212
(43) Date de publication de la demande: 12.10.2016
(73) Titulaire: SAGEMCOM BROADBAND SAS, 92500 Rueil-Malmaison (FR)
(72) Inventeur: SUSINI, Dominique, F-92500 Rueil Malmaison (FR); SIRON, Daniel, F-92500 Rueil Malmaison (FR); EVRARD, Etienne, F-92500 Rueil Malmaison (FR); DANGY-CAYE, Nicolas, F-92500 Rueil Malmaison (FR); NEDELCU, Radu, F-92500 Rueil Malmaison (FR)
(74) Mandataire: Lavaud, Thomas
(86) Numéro de dépôt international: PCT/EP2014/076318
(87) Numéro de publication internationale: WO 2015/082503

(56) Documents cités:
- WO-A1-01/74015
- WO-A2-2008/086138
- US-A1- 2006 094 291
- US-A1- 2013 016 493

## Description

L'invention concerne un module électrique adapté à fonctionner en étant connecté ou non à au moins un autre module électrique de même type.

### ARRIERE PLAN DE L'INVENTION

Un certain nombre d'installations électriques domestiques nécessitent de connecter entre eux plusieurs équipements ou modules électriques. Parmi ces installations, on peut citer une installation «multimédia », qui regroupe par exemple une passerelle Internet, un décodeur pour la télévision, une console de jeux vidéo, etc. On peut aussi citer une installation acoustique « Hi-Fi », qui regroupe par exemple un amplificateur, une platine CD, un tuner, etc.

De nombreux câbles électriques sont utilisés dans ce type d'installation pour relier chaque module électrique à une prise électrique du secteur, pour relier un ou plusieurs modules électriques au réseau internet, pour relier les modules entre eux de manière à permettre des échanges de données entre ces modules, etc.

L'utilisation de ces nombreux câbles pose certains problèmes. Les câbles rendent l'installation électrique peu esthétique, et obligent parfois à mettre en œuvre des opérations complexes pour les dissimuler. Une telle installation électrique requiert en outre la disponibilité d'un certain nombre de prises électriques secteur à proximité de l'installation, ou bien l'utilisation d'une multiprise additionnelle pour relier chaque module électrique au secteur. Enfin, la connexion des différents modules électriques entre eux est relativement complexe et peut présenter des difficultés pour un utilisateur non chevronné. Il est mentionné que le document WO 2008/086138 A2 définit un module électrique connu.

### OBJET DE L'INVENTION

L'invention a pour objet un module électrique adapté à être intégré dans une installation électrique telle que celles évoquées plus tôt et dont l'utilisation permet de réduire le nombre de câbles et de prises électriques secteur nécessaires au fonctionnement de l'installation, et de simplifier la connexion des modules au sein de l'installation.

### RESUME DE L'INVENTION

En vue de la réalisation de ce but, on propose un module électrique tel que défini dans la revendication 1. Celui-ci est adapté à fonctionner en étant connecté ou non à au moins un autre module électrique de même type. Le module électrique comporte un boîtier sur lequel sont agencés des premiers moyens de connexion adaptés à connecter le module électrique à une alimentation externe et des deuxièmes moyens de connexion permettant au module électrique d'échanger des premières données avec l'extérieur. Le module électrique comporte en outre des moyens de liaison qui sont fixés au boîtier et sont adaptés à connecter le module électrique à un autre module électrique de même type pour lui transmettre des données de liaison et/ou une alimentation de liaison.

Lorsque plusieurs modules électriques de l'invention sont connectés au sein d'une même installation électrique, ceux-ci sont connectés entre eux via les moyens de liaison. Ainsi, il suffit qu'un seul module électrique soit connecté à une prise électrique secteur pour que tous les modules soient alimentés, le module électrique connecté à la prise secteur fournissant l'alimentation de liaison aux autres modules électriques, via les moyens de liaison, pour les alimenter. De même, les modules électriques peuvent échanger entre eux des données de liaison via les moyens de liaison. On réduit donc drastiquement le nombre de câbles électriques d'alimentation et de transmission de données nécessaires dans l'installation, ce qui améliore l'aspect esthétique de l'installation. On réduit aussi le nombre de prises électriques secteur nécessaire. En outre, la connexion des modules électriques au sein de l'installation consiste uniquement à connecter un câble d'alimentation standard à un module électrique, et de connecter les modules électriques entre eux via les moyens de liaison, ce qui simplifie fortement les opérations de connexion et réduit le risque d'erreur de connexion.

L'invention sera mieux comprise à la lumière de la description qui suit d'un mode de mise en œuvre particulier non limitatif de l'invention.

### BREVE DESCRIPTION DES DESSINS

Il sera fait référence aux dessins annexés, parmi lesquels :
- la figure 1 est une vue en perspective de trois modules électriques de l'invention ;
- la figure 2 représente des moyens de liaison du module électrique de l'invention ;
- la figure 3 représente un premier connecteur électrique du module électrique de l'invention ;
- la figure 4 représente un deuxième connecteur électrique des moyens de liaison du module électrique de l'invention ;
- la figure 5a représente une fiche femelle d'un connecteur électrique femelle du module électrique de l'invention selon un premier mode de réalisation ;
- la figure 5b représente une fiche mâle des moyens de liaison complémentaire de la fiche femelle représentée sur la figure 5a ;
- la figure 6a représente une fiche femelle d'un connecteur électrique femelle du module électrique de l'invention selon un deuxième mode de réalisation ;
- la figure 6b représente une fiche mâle des moyens de liaison complémentaire de la fiche femelle représentée sur la figure 6a ;
- la figure 7a représente une fiche femelle d'un connecteur électrique femelle du module électrique de l'invention selon un troisième mode de réalisation ;
- la figure 7b représente une fiche mâle des moyens de liaison complémentaire de la fiche femelle représentée sur la figure 7a ;
- la figure 8a représente une fiche femelle d'un connecteur électrique femelle du module électrique de l'invention selon un quatrième mode de réalisation ;
- la figure 8b représente une fiche mâle des moyens de liaison complémentaire de la fiche femelle représentée sur la figure 8a.

### DESCRIPTION DETAILLEE DE L'INVENTION

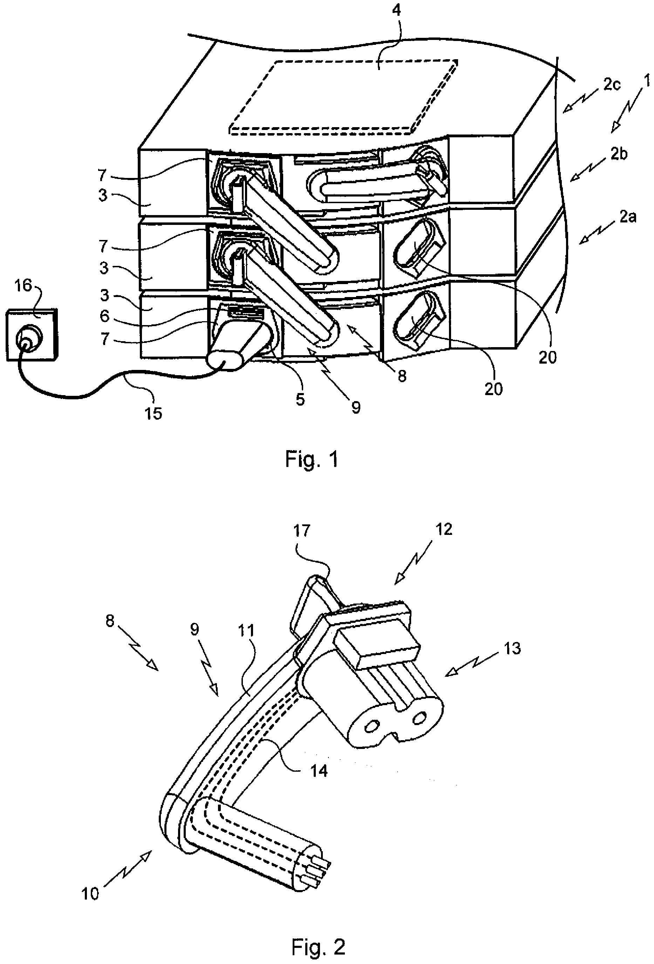

En référence à la figure 1, l'invention est ici illustrée dans une installation électrique domestique 1 comportant un premier, un deuxième et un troisième modules électriques 2a, 2b, 2c de l'invention. Dans le cadre d'une installation multimédia, il pourrait s'agir par exemple d'une passerelle domestique Internet, d'un décodeur pour la télévision et d'une console de jeux vidéo, ladite installation multimédia comportant alors en plus une télévision, non représentée, connectée aux modules électriques précités.

Chacun des modules électriques 2 est adapté à fonctionner en étant connecté ou non à un autre module électrique de même type. Par « de même type », on entend que ces modules électriques possèdent des interfaces électriques compatibles et sont adaptés à coopérer pour réaliser ensemble au moins une fonction particulière. Ainsi, à nouveau dans le cadre d'une installation multimédia, la console de jeux vidéo peut fonctionner de manière autonome mais peut aussi être connectée à la passerelle domestique pour recevoir du réseau Internet des données permettant par exemple d'interagir avec d'autres joueurs.

Chaque module électrique 2 comporte un boîtier 3 à l'intérieur duquel est montée au moins une carte électrique 4 adaptée à mettre en œuvre des fonctions propres au module électrique 2 et éventuellement des fonctions particulières résultant d'une éventuelle coopération entre modules.

Des premiers moyens de connexion 5 et des deuxièmes moyens de connexion 6 regroupés dans un même premier connecteur électrique 7, en l'occurrence un connecteur femelle, ainsi que des moyens de liaison 8 sont agencés sur chaque boîtier 3.

Les premiers moyens de connexion 5 sont destinés à connecter le module électrique à une alimentation externe au module en question. Par « alimentation externe », on entend aussi bien une alimentation fournie via une prise électrique secteur qu'une alimentation fournie par un autre module électrique 2.

Les deuxièmes moyens de connexion 6 permettent au module électrique 3 d'échanger des premières données avec l'extérieur du module électrique 3. Par « l'extérieur du module électrique », on entend ici que les premières données sont échangées avec un équipement quelconque ou avec un autre module électrique 2.

Les moyens de liaison 8 comportent un bras 9, mieux visible sur la figure 2, qui lui-même comporte une première extrémité 10 fixée au boîtier 3, un corps 11, une deuxième extrémité 12 comprenant un deuxième connecteur électrique mâle 13 complémentaire du premier connecteur électrique 7, et une zone de préhension 17 situé sur la deuxième extrémité 12. Des câbles électriques 14 connectant la première extrémité 10 et le deuxième connecteur électrique 13 circulent dans le corps 11 du bras 9.

Le premier connecteur électrique 7 et le bras 9 des modules électriques 3 sont donc ici utilisés, d'une part, pour assurer une alimentation des trois modules électriques 2 de l'installation électrique domestique et, d'autre part, pour assurer des échanges de données de liaison entre les trois modules électriques 2.

On décrit maintenant plus en détail la manière dont sont connectés électriquement entre eux le premier module électrique 2a, le deuxième module électrique 2b, et le troisième module électrique 2c.

Le premier module électrique 2a est connecté via les premiers moyens de connexion 5 du premier connecteur électrique 7 du premier module électrique 2a et via un câble d'alimentation standard 15 à une prise électrique secteur 16. La carte électrique 4 du premier module électrique 2a comprend un circuit d'alimentation qui est ainsi alimenté par la tension fournie par la prise électrique secteur 16. Le circuit d'alimentation de la carte électrique 4 du premier module électrique 2a fournit une ou plusieurs alimentations au reste de la carte électrique 4 et une alimentation de liaison au deuxième module 2b via le bras 9 du premier module électrique 2a, ladite alimentation de liaison étant adaptée à alimenter la carte électrique 4 du deuxième module électrique 2b.

De plus, la carte électrique 4 du module électrique 2a et la carte électrique 4 du module électrique 2b échangent des données de liaison via le bras 9 du premier module électrique 2a. Le deuxième connecteur électrique 13 du bras 9 du premier module électrique 2a est connecté à cet effet au premier connecteur électrique 7 du deuxième module électrique 2b.

Le deuxième module électrique 2b est donc alimenté par le premier module électrique 2a, et est adapté à échanger des données de liaison avec le premier module électrique 2a.

Le deuxième module électrique 2b est de plus connecté au troisième module électrique 2c. La carte électrique 4 du deuxième module électrique 2b fournit une alimentation de liaison au troisième module électrique 2c via le bras 9 du deuxième module électrique 2b. De plus, la carte électrique 4 du deuxième module électrique 2b et la carte électrique 4 du troisième module électrique 2c échangent des données de liaison via le bras 9 du deuxième module électrique 2b. Le deuxième connecteur électrique 13 du bras 9 du deuxième module électrique 2b est connecté à cet effet au premier connecteur électrique 7 du troisième module électrique 2c.

Le troisième module électrique 2c est donc alimenté par le deuxième module électrique 2b, et est adapté à échanger des données de liaison avec le deuxième module électrique 2b.

Ainsi, les données de liaison échangées entre le premier module électrique 2a et le troisième module électrique 2c transitent par le deuxième module électrique 2b.

On note donc que les bras 9 du premier module électrique 2a et du deuxième module électrique 2b sont respectivement connectés au deuxième module électrique 2b et au troisième module électrique 2c, alors que le bras 9 du troisième module électrique 2c n'est pas utilisé. On appelle « position de connexion » la position dans laquelle se trouve le bras 9 des modules électriques 2a, 2b qui est connecté à une autre module électrique, et « position de repos » la position dans laquelle se trouve le bras 9 du troisième module 2c qui n'est pas connecté à un autre module électrique.

Chaque boîtier 3 de module électrique 2 comporte un connecteur électrique femelle factice 20 complémentaire du deuxième connecteur électrique 13 et adapté à recevoir le deuxième connecteur électrique 13 lorsque le bras est positionné dans la position de repos. La première extrémité 10 du bras 9 est montée pivotante sur le boîtier 3, de sorte qu'un utilisateur peut sélectivement positionner le bras 9 en position de connexion ou en position de repos en le saisissant manuellement par la zone de préhension 17 et en le faisant pivoter.

Le bras 9 a une longueur déterminée en fonction de la hauteur des modules 2 pour être suffisante pour permettre de relier électriquement les deux modules.

Le bras 9 est ici fixé au boîtier 3 du module électrique 2 et ne peut en être retiré. Alternativement, on peut prévoir un bras 9 qui soit fixé de manière amovible au boîtier 3 pour pouvoir être désolidarisé du boîtier 3 et éventuellement être monté sur un autre module électrique 2.

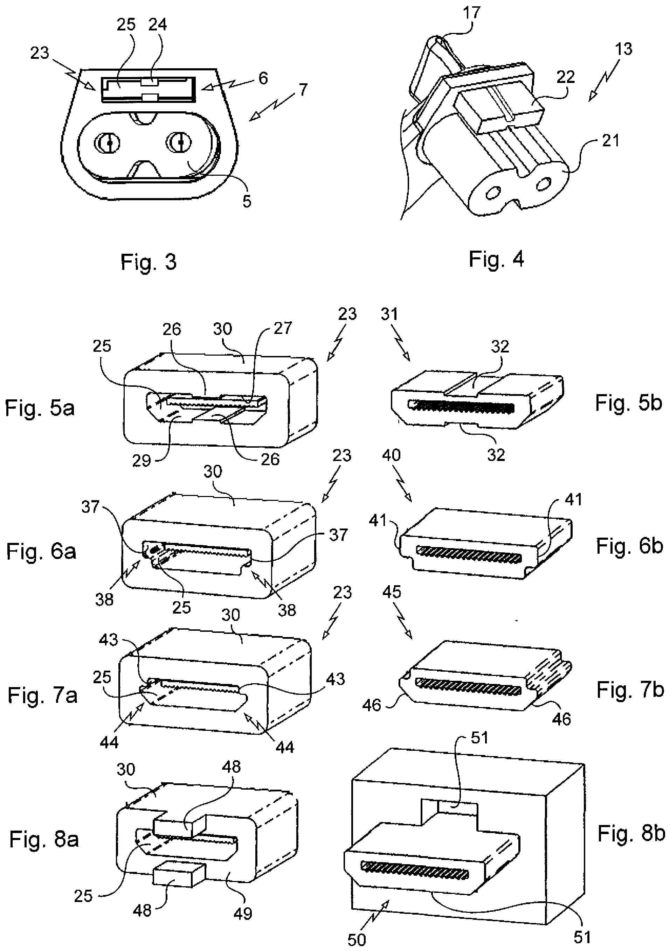

On décrit maintenant plus en détail le premier connecteur électrique 7 d'un module électrique 2 et le deuxième connecteur électrique 13 d'un bras 9, en référence aux figures 3 et 4.

Le premier connecteur électrique 7 est un connecteur femelle qui regroupe les premiers moyens de connexion 5 adaptés à transmettre une alimentation, et les deuxièmes moyens de connexion 6 adaptés à transmettre des données numériques. Le deuxième connecteur électrique 13 est un connecteur mâle complémentaire du premier connecteur, qui comporte des troisièmes moyens de connexion 21 complémentaires des premiers moyens de connexion 5 et des quatrièmes moyens de connexion 22 complémentaires des deuxièmes moyens de connexion 6 du module électrique 2.

Le connecteur électrique 13 est orienté par rapport au bras 9 en fonction de l'angle que fait le bras 9 lorsque le bras 9 relie deux modules 2.

Les premiers moyens de connexion 5 du premier connecteur 7 comportent un connecteur électrique femelle d'alimentation standard conforme au standard « IEC 60320-1 » de type C7. Les troisièmes moyens de connexion 21 du deuxième connecteur électrique 13 comportent donc un connecteur électrique mâle d'alimentation standard conforme au standard « IEC 60320-1 » de type C7. Ainsi, un module électrique 2 peut aussi bien être alimenté par une prise électrique secteur via un câble électrique comportant à son extrémité libre un connecteur électrique mâle conforme au standard précité, comme c'est le cas pour le premier module électrique 2a, que par un autre module électrique, comme c'est le cas pour les deuxième et troisième modules électriques 2b, 2c.

Avantageusement, les deuxièmes moyens de connexion 6 du premier connecteur électrique 7 comportent un connecteur électrique femelle non standard 23 comportant des moyens mécaniques de sécurisation 24 de manière à pouvoir être connectés uniquement à un bras 9 d'un autre module électrique. Les premières données échangées par chaque module électrique avec l'extérieur via le bras 9 sont constituées uniquement par les données de liaison provenant d'un autre module.

Le connecteur électrique femelle 23 des deuxièmes moyens de connexion comporte une fiche femelle 30 définissant un logement de connexion 25 à l'intérieur duquel des contacts sont agencés conformément au standard HDMI.

Les moyens mécaniques de sécurisation sont adaptés à interdire une connexion d'un connecteur mâle HDMI standard au connecteur électrique femelle 23. Ainsi, un utilisateur ne peut par erreur connecter un connecteur HDMI standard provenant d'un équipement de type différent (par exemple d'un caméscope) au connecteur électrique femelle 23 d'un module électrique 2.

En référence à la figure 5a, les moyens mécaniques de sécurisation 24 sont définis par une forme intérieure du logement de connexion 25, laquelle forme intérieure présente au moins une nervure 26 située sur au moins une surface intérieure du logement de connexion. En l'occurrence, la forme intérieure du logement de connexion 25 présente une première nervure 26 située au centre d'une face intérieure supérieure 27 du logement de connexion et une deuxième nervure 26 située au centre d'une face intérieure inférieure 29 du logement de connexion 25.

Lorsque le connecteur électrique femelle 23 comporte les moyens mécaniques de sécurisation 24 selon le premier mode de réalisation, les quatrièmes moyens de connexion 22 comportent une fiche mâle 31, visible sur la figure 5b, complémentaire de la fiche femelle en question, c'est-à-dire une fiche mâle qui comporte des contacts agencés conformément au standard HDMI, et dont la forme extérieure présente deux rainures 32 complémentaires des nervures 26 du logement de connexion 25 de la fiche femelle 30 du connecteur électrique femelle 23.

Dans un second mode de réalisation visible sur la figure 6a, les moyens mécaniques de sécurisation 24 sont définis par une forme intérieure du logement de connexion 25 qui est délimité par deux parois latérales 37 pourvue chacune d'une nervure de section carrée ou rectangulaire 38 s'étendant selon une direction d'introduction de la fiche mâle du connecteur électrique mâle correspondant dans le logement. La fiche mâle 40 des quatrièmes moyens de connexion 22 comporte alors des rainures complémentaires 41 de section carrée ou rectangulaire disposées pour recevoir avec les nervures 38.

Dans un troisième mode de réalisation, visible sur la figure 7a, le logement de connexion 25 est délimité par deux parois latérales 43 dans chacune desquelles est ménagée une rainure de section triangulaire 44. La fiche mâle 45 des quatrièmes moyens de connexion 22 comporte alors des nervures complémentaires 46 de section triangulaire.

Dans un quatrième mode de réalisation, visible sur la figure 8a, les moyens mécaniques de sécurisation 24 comportent au moins une protubérance 48 saillant d'une surface frontale 49 de la fiche femelle 30 pour s'étendre parallèlement à la direction d'engagement de la fiche mâle 50 dans la fiche femelle 30. En l'occurrence, la fiche femelle 30 comporte deux protubérances 48 situées de part et d'autre du logement de connexion 25. La fiche mâle 50 des quatrièmes moyens de connexion 22 comporte alors deux logements d'accueil 51 complémentaires des protubérances 48. Ces protubérances 48 ont une longueur suffisante permettre une insertion au plus partielle d'une fiche mâle HDMI standard dans la fiche femelle du connecteur électrique femelle, mais interdisent toute connexion électrique entre les contacts de ces deux fiches.

L'invention n'est pas limitée aux modes de mise en œuvre particuliers qui viennent d'être décrits, mais, bien au contraire, couvre toute variante entrant dans le cadre de l'invention telle que définie par les revendications.

Le boîtier du module électrique peut bien sûr comporter d'autres moyens de connexion permettant de connecter le module électrique à une alimentation externe ou à un autre équipement. En particulier, le boîtier peut comporter un connecteur additionnel standard agencé sur le boîtier et permettant au module électrique d'échanger des deuxièmes données avec l'extérieur, ledit connecteur additionnel étant par exemple un connecteur standard permettant d'accéder au réseau internet via un câble standard.

Les deuxièmes moyens de connexion peuvent être à un autre standard que le standard HDMI et par exemple au standard USB, Firewire ou autre.

Le bras peut être télescopique et les moyens de connexion 21 et 22 peuvent être montés sur un support orientable.

Les données de liaison peuvent avoir été émises par le module électrique 2a à destination du module électrique 2c et donc simplement transiter par le module électrique 2b, ou bien avoir été émises par le module électrique 2b à destination du module électrique 2c.

## Revendications

1. Module électrique (2a-2c) adapté à fonctionner en étant connecté ou non à au moins un autre module électrique (2a-2c), le module électrique (2a-2c) comportant un boîtier (3) sur lequel sont agencés des premiers moyens de connexion (5) adaptés à connecter le module électrique (2a-2c) à une alimentation externe et des deuxièmes moyens de connexion (6) permettant au module électrique (2a-2c) d'échanger des premières données avec l'extérieur, les premiers moyens de connexion (5) et les deuxièmes moyens de connexion (6) étant regroupés dans un même premier connecteur (7), le module électrique comportant en outre des moyens de liaison (8) qui sont fixés au boîtier et sont adaptés à connecter le module électrique (2) à un autre module électrique pour lui transmettre des données de liaison et/ou une alimentation de liaison, les moyens de liaison (8) comportant un bras ayant une première extrémité (10) fixée au boîtier (3) et une deuxième extrémité (12) comprenant un deuxième connecteur (13) adapté à être connecté à l'autre module électrique (2a-2c), le deuxième connecteur (13) étant complémentaire du premier connecteur (7), le bras des moyens de liaison (8) étant adapté à pivoter par rapport au boîtier au niveau de la première extrémité (10) de sorte que les moyens de liaison puissent être positionnés dans une position de connexion dans laquelle le deuxième connecteur (13) est adapté à être connecté à l'autre module électrique (2a-2c), et dans une position de repos dans laquelle le deuxième connecteur (13) n'est pas connecté à l'autre module électrique (2a-2c).

2. Module électrique (2a-2c) selon la revendication 1, dans lequel les moyens de liaison (8) sont fixés de manière amovible au boîtier pour pouvoir être désolidarisés du module électrique (2a-2c).

3. Module électrique (2a-2c) selon l'une des revendications précédentes, dans lequel les moyens de liaison (8) comportent une zone de préhension (17) au niveau de la deuxième extrémité et des câbles électriques (14) cheminant à l'intérieur du bras entre la première extrémité et la deuxième extrémité.

4. Module électrique (2a-2c) selon la revendication 1, dans lequel le boîtier comporte un connecteur factice (20) complémentaire du deuxième connecteur (13) et adapté à accueillir le deuxième connecteur (13) lorsque les moyens de liaison sont dans la position de repos.

5. Module électrique (2a-2c) selon l'une des revendications précédentes, dans lequel les deuxièmes moyens de connexion (6) comportent des moyens de sécurisation mécanique (24) de manière à pouvoir être connectés uniquement à des moyens de liaison de l'autre module électrique (2a-2c).

6. Module électrique (2a-2c) selon l'une des revendications précédentes comportant en outre un connecteur additionnel standard agencé sur le boîtier et permettant au module électrique (2a-2c) d'échanger des deuxièmes données avec l'extérieur.

## Patentansprüche

1. Elektrisches Modul (2a-2c), das betriebsfähig ist, indem es mit mindestens einem anderen elektrischen Modul (2a-2c) verbunden ist oder nicht, wobei das elektrische Modul (2a-2c) ein Gehäuse (3) umfasst, an dem erste Anschlussmittel (5) ausgebildet sind, die geeignet sind, das elektrische Modul (2a-2c) mit einer äußeren Versorgung zu verbinden, sowie zweite Anschlussmittel (6), die dem elektrischen Modul (2a-2c) ermöglichen, erste Daten mit der Außenwelt auszutauschen, wobei die ersten Anschlussmittel (5) und die zweiten Anschlussmittel (6) in einem selben ersten Verbinder (7) zusammengefasst sind, wobei das elektrische Modul ferner Verbindungsmittel (8) umfasst, die an dem Gehäuse befestigt und dazu geeignet sind, das elektrische Modul (2) mit einem anderen elektrischen Modul zu verbinden, um ihm Verbindungsdaten und/oder eine Verbindungsversorgung zu übertragen, wobei die Verbindungsmittel (8) einen Arm umfassen, der ein erstes Ende (10) hat, das an dem Gehäuse (3) befestigt ist, sowie ein zweites Ende (12), das einen zweiten Verbinder (13) umfasst, der geeignet ist, mit dem anderen elektrischen Modul (2a-2c) verbunden zu werden, wobei der zweite Verbinder (13) komplementär zu dem ersten Verbinder (7) ist, wobei der Arm der Verbindungsmittel (8) dazu geeignet ist, sich relativ zum Gehäuse im Bereich des ersten Endes (10) derart zu drehen, dass die Verbindungsmittel in einer Verbindungsposition positioniert werden können, in der der zweite Verbinder (13) geeignet ist, mit dem anderen elektrischen Modul (2a-2c) verbunden zu werden, und in einer Ruheposition, in der der zweite Verbinder (13) nicht mit dem anderen elektrischen Modul (2a-2c) verbunden ist.

2. Elektrisches Modul (2a-2c) nach Anspruch 1, bei dem die Verbindungsmittel (8) lösbar an dem Gehäuse befestigt sind, um von dem elektrischen Modul (2a-2c) gelöst werden zu können.

3. Elektrisches Modul (2a-2c) nach einem der vorhergehenden Ansprüche, bei dem die Verbindungsmittel (8) eine Greifzone (17) im Bereich des zweiten Endes und elektrische Kabel (14) umfassen, die im Inneren des Arms zwischen dem ersten Ende und dem zweiten Ende verlaufen.

4. Elektrisches Modul (2a-2c) nach Anspruch 1, bei dem das Gehäuse einen Scheinverbinder (20) hat, der komplementär zum zweiten Verbinder (13) und dazu geeignet ist, den zweiten Verbinder (13) aufzunehmen, wenn die Verbindungsmittel in der Ruheposition sind.

5. Elektrisches Modul (2a-2c) nach einem der vorhergehenden Ansprüche, bei dem die zweiten Anschlussmittel (6) Mittel (24) zur mechanischen Sicherung umfassen, derart, dass sie nur mit den Verbindungsmitteln des anderen elektrischen Moduls (2a-2c) verbunden werden können.

6. Elektrisches Modul (2a-2c) nach einem der vorhergehenden Ansprüche, ferner umfassend einen zusätzlichen Standardverbinder, der an dem Gehäuse ausgebildet ist und dem elektrischen Modul (2a-2c) ermöglicht, zweite Daten mit der Außenwelt auszutauschen.

## Claims

1. An electrical module (2a, 2c) adapted to operate while optionally connected to at least one other electrical module (2a, 2c), the electrical module (2a, 2c) comprising a box (3) having arranged thereon first connection means (5) suitable for connecting the electrical module (2a, 2c) to an external power supply, and second connection means (6) enabling the electrical module (2a, 2c) to exchange first data externally, the first connection means (5) and the second connection means (6) being grouped together in a single first connector (7), the electrical module also including link means (8) that are fastened to the box and that are adapted to connect the electrical module (2) to another electrical module of the same type in order to convey thereto link data and/or a link power supply,
the link means (8) comprising an arm having a first end (10) fastened to the box (3) and a second end (12) having a second connector (13) adapted to be connected to the other electrical module (2a, 2c) , the second connector (13) being complementary to the first connector (7), the arm of the link means (8) being adapted to pivot relative to the box at the first end (10) so that the link means can be positioned in a connection position in which the second connector (13) is adapted to be connected to the other electrical module (2a, 2c), and in a rest position in which the second connector (13) is not connected to the other electrical module (2a, 2c).

2. The electrical module (2a, 2c) according to claim 1, wherein the link means (8) are fastened to the box in releasable manner so as to be capable of being separated from the electrical module (2a, 2c).

3. The electrical module according to one of the preceding claims, wherein the link means (8) include a grip zone (17) at the second end and electric cables (14) running inside the arm between the first end and the second end.

4. The electrical module according to claim 1, wherein the box includes a dummy connector (20) complementary to the second connector (13) and adapted to receive the second connector (13) when the link means are in the rest position.

5. The electrical module (2a, 2c) according to one of the preceding claims, wherein the second connection means (6) include mechanical safety means so as to be capable of being connected only to link means of another electrical module of the same type (2a, 2c).

6. The electrical module (2a, 2c) according to one of the preceding claims, further including a standard additional connector arranged on the box and enabling the electrical module (2a, 2c) to exchange second data externally.
